# EUROPEAN PATENT APPLICATION

(11) **EP 4 831 131 A1**
(43) Date of publication of application: **28.10.2026**
(21) Application number: 24907953.4
(22) Date of filing: 10.12.2024
(51) Int. Cl.: C01G 39/04, B01J 8/08, B01J 8/10, B01J 19/08, B01J 19/20, C23C 16/14

(54) **APPARATUS AND METHOD FOR PRODUCING MOLYBDENUM OXYHALIDE**

(30) Priority: 19.12.2023 KR 20230186407
(71) Applicant: POSCO Co., Ltd, Gyeongsangbuk-do 37859 (KR); Research Institute of Industrial Science & Technology, Pohang-si, Gyeongsangbuk-do 37673 (KR)
(72) Inventor: JUNG, Suk-Yong, Cheongju-si, Chungcheongbuk-do 28123 (KR); JEONG, Cheon-Woo, Suncheon-si, Jeollanam-do 58006 (KR); PARK, Seoung-Woong, Pohang-si, Gyeongsangbuk-do 37673 (KR); KIM, Joon-Woo, Suncheon-si, Jeollanam-do 58006 (KR)
(74) Representative: Nederlandsch Octrooibureau
(86) International application number: PCT/KR2024/020191
(87) International publication number: WO 2025/135669

(57) **Abstract**

An apparatus for producing molybdenum oxyhalide according to one aspect of the present disclosure comprises a reaction zone to which a halogen-containing gas is supplied, wherein a raw material containing molybdenum oxide is transferred so as to pass through the reaction zone, and molybdenum oxyhalide is produced.

## Description

### Technical Field

The present disclosure relates to an apparatus and method for producing molybdenum oxyhalide, and more particularly, to an apparatus and method capable of mass-producing molybdenum oxyhalide.

### Background Art

Tungsten, having excellent thermal stability and a specific resistance value, is used as a wiring material of memory semiconductors. However, tungsten, used as a wiring material of 8th-production or higher, has a limitation in that contact resistance increases rapidly at a level at which a transistor circuit linewidth is less than 5 nm. Accordingly, molybdenum (Mo) is emerging as a next-generation material to replace tungsten.

Molybdenum (Mo) has a low value of bulk resistivity × mean free path, thereby enabling reduction of a vertical pitch in vertical stack down (VSD), and enabling transition to a device structure without a barrier or an adhesion layer.

In order to form molybdenum wiring through deposition processes such as atomic layer deposition or chemical vapor deposition, development of a molybdenum precursor satisfying deposition characteristics such as deposition uniformity, step coverage, and gap-fill properties should be preceded.

Currently, molybdenum oxyhalide is attracting attention as a molybdenum precursor satisfying deposition characteristics required for semiconductor wiring.

Molybdenum oxyhalides such as MoO₂Cl₂ and MoOCl₄ may be synthesized by heating while contacting molybdenum oxide with a halogen gas (for example, Cl₂), and a high-purity molybdenum precursor is produced by purifying the synthesized molybdenum oxyhalide.

In order for molybdenum wiring to be commercially utilized in high-density memory semiconductors such as 3D NAND, mass production technology for high-purity molybdenum oxyhalide needs to be established; however, production of molybdenum oxyhalide has been limited to a batch-type process.

### Summary of Invention

### Technical Problem

An aspect of the present disclosure is to provide an apparatus and method for mass-producing high-purity molybdenum oxyhalide.

The subject of the present disclosure is not limited to the above. Those skilled in the art to which the present disclosure pertains will have no difficulty in understanding the additional objects of the present disclosure from the contents throughout the present specification.

### Solution to Problem

According to an aspect of the present disclosure, an apparatus for producing molybdenum oxyhalide includes a reaction zone to which a halogen-containing gas is supplied, in which a raw material containing molybdenum oxide is transferred so as to pass through the reaction zone, and molybdenum oxyhalide is produced.

The raw material may be transferred continuously.

An average transfer speed of the raw material passing through the reaction zone may be 0.01 m/hr to 10.0 m/hr.

At least one energy selected from the group consisting of thermal energy, light energy, and vibrational energy may be applied to the reaction zone.

The apparatus may further include a case providing an internal space including the reaction zone, and an energy application unit applying energy to the reaction zone.

The apparatus may further include a transfer means transferring the raw material to pass through the reaction zone.

The transfer means may include a transfer shaft rotatably equipped with a transfer blade, or a belt moving in a designed direction.

A material of the case may be a non-metallic inorganic material in a crystalline, amorphous, or a composite phase in which crystalline and amorphous phases are mixed.

In the internal space, a partition wall for preventing gas backflow may be provided in front of an inlet point where the halogen-containing gas is introduced, relative to a transfer direction of the raw material.

The apparatus may further include a first gas supply unit including a first gas cylinder storing a halogen gas and a first moisture adsorber, and a second gas supply unit including a second gas cylinder storing inert gas and a second moisture adsorber.

The apparatus may further include a gas purifier removing moisture from the halogen-containing gas including a halogen gas supplied from the first gas supply unit and an inert gas supplied from the second gas supply unit.

The apparatus may further include a residue storage unit for receiving and storing a residual solid phase discharged from the reaction zone, and a residue heating unit heating the residue storage unit.

The apparatus may further include a collection unit receiving the gaseous molybdenum oxyhalide and collecting the gaseous molybdenum oxyhalide into a solid phase.

The apparatus may further include a heating unit heating a wall surface that contacts the gaseous molybdenum oxyhalide discharged from the reaction zone and partitions a space used for transferring or storing the gaseous molybdenum oxyhalide.

According to another aspect of the present disclosure, an apparatus for producing molybdenum oxyhalide includes a raw material supply unit supplying a raw material containing molybdenum oxide, a reaction transfer unit including a reaction zone to which a halogen-containing gas is supplied and energy is applied, the raw material supplied from the raw material supply unit being transferred to pass through the reaction zone and molybdenum oxyhalide being produced, a collection unit receiving gaseous molybdenum oxyhalide discharged from the reaction transfer unit and collecting the gaseous molybdenum oxyhalide into a solid phase, a purification unit receiving the solid molybdenum oxyhalide collected in the collection unit and sublimating the received solid molybdenum oxyhalide into a gas, and a solidification unit receiving and solidifying the sublimated molybdenum oxyhalide.

The apparatus may further include a raw material heating unit heating the raw material within the raw material supply unit.

The apparatus may further include a line heating unit heating at least one selected from the group consisting of a first line which is a transfer line between an outlet through which gaseous molybdenum oxyhalide is discharged from the reaction transfer unit and an inlet through which the gaseous phase is introduced to the collection unit, a second line which is a transfer line between an outlet through which the sublimated molybdenum oxyhalide is discharged from the purification unit and an inlet through which the sublimated molybdenum oxyhalide is introduced to the solidification unit, and a third line which is a transfer line between a solid outlet through which a residual solid phase is discharged from the reaction transfer unit and a solid inlet of a residue storage unit that receives and stores the residual solid phase.

The apparatus may further include a purification transfer unit transferring the solid phase collected in the collection unit to the purification unit, and a transfer heating unit heating the purification transfer unit.

The solidification unit may include a solidification body having an internal space and provided with an inlet formed at an upper end portion thereof through which the sublimated molybdenum oxyhalide is introduced, a cooling plate accommodated in the solidification body to cool the sublimated molybdenum oxyhalide, and a solidification heating unit heating at least an upper end portion of the solidification body where the inlet is formed.

The apparatus may further include a housing providing an internal space where the raw material supply unit, the reaction transfer unit, the collection unit, the purification unit, and the solidification unit are positioned, and a moisture removal unit removing moisture from an atmosphere within the housing.

According to still another aspect of the present disclosure, a method for producing molybdenum oxyhalide includes passing a raw material containing molybdenum oxide through a reaction zone, supplying a halogen-containing gas to the reaction zone, and generating molybdenum oxyhalide.

The raw material may flow and pass through the reaction zone.

An average transfer speed of the raw material passing through the reaction zone may be 0.01 m/hr to 10.0 m/hr.

At least one energy selected from the group consisting of thermal energy, light energy, and vibrational energy may be applied to the reaction zone.

Moisture may be removed from the raw material before the raw material is supplied to the reaction zone.

The halogen-containing gas may be a mixed gas of halogen gas and inert gas, and moisture may be removed from the mixed gas before the mixed gas is supplied to the reaction zone.

A temperature of the reaction zone may be 190 to 350°C.

A time required for the raw material to pass through the reaction zone may be 10 minutes to 600 minutes.

The halogen-containing gas may be supplied to the reaction zone such that, based on a stoichiometric ratio of the molybdenum oxyhalide, the number of moles of halogen atoms required to generate 1 mole of the molybdenum oxyhalide is set as the reference number of moles, and 1 to 10 times the reference number of moles of halogen element is supplied.

The method may further include cooling the produced gaseous molybdenum oxyhalide and collecting the cooled molybdenum oxyhalide into a solid phase.

The supply of the raw material to the reaction zone and the collection into the solid phase may be performed simultaneously.

A wall surface partitioning a space used for transferring the gaseous molybdenum oxyhalide discharged from the reaction zone may be heated.

According to still another aspect of the present disclosure, a method for producing molybdenum oxyhalide includes S1) transferring a raw material containing molybdenum oxide to pass through a reaction zone to which a halogen-containing gas is supplied and energy is applied, and generating molybdenum oxyhalide, S2) receiving and cooling the gaseous molybdenum oxyhalide produced in step S1) and collecting the molybdenum oxyhalide into a solid phase, S3) sublimating the collected solid molybdenum oxyhalide into a gas, and S4) solidifying the sublimated molybdenum oxyhalide.

In S1), the raw material may be continuously supplied to the reaction zone, and in S2), the gaseous molybdenum oxyhalide may be continuously collected.

One or more wall surfaces selected from the group consisting of a wall surface partitioning a space used for transferring the gaseous molybdenum oxyhalide discharged from the reaction zone and a wall surface partitioning a space used for transferring the sublimated molybdenum oxyhalide in S3) may be heated.

The molybdenum oxyhalide may be heated when transferred to a purification unit where the sublimation of S3) of the molybdenum oxyhalide collected in the solid phase is performed.

The space where S1) through S4) are performed may be positioned under an atmosphere from which moisture is removed.

The halogen-containing gas may be a chlorine-containing gas, and the molybdenum oxyhalide may be molybdenum dioxydichloride.

The molybdenum oxide may be molybdenum dioxide.

The molybdenum oxyhalide may be a precursor for depositing molybdenum metal.

The molybdenum oxyhalide may be a material for forming one or more electrodes selected from the group consisting of an anode and a cathode of a diode and a source, a drain, and a gate of a transistor, or a material for forming one or more lines selected from the group consisting of word lines and bit lines of a memory device.

According to an aspect of the present disclosure, there is provided molybdenum oxyhalide produced by a production method described above.

### Advantageous Effects of Invention

According to an aspect of the present disclosure, an apparatus and a method for producing molybdenum oxyhalide can continuously produce molybdenum oxyhalide, thereby enabling mass production of molybdenum oxyhalide.

According to an aspect of the present disclosure, the apparatus and the method for producing molybdenum oxyhalide can allow synthesis and purification to be performed without exposure to the outside air, thereby enabling the molybdenum oxyhalide to be free from contamination.

According to an aspect of the present disclosure, the apparatus and the method for producing molybdenum oxyhalide can produce high-purity molybdenum oxyhalide having a purity of 5 nines (99.999%) or higher.

According to an aspect of the present disclosure, the apparatus and the method for producing molybdenum oxyhalide can produce molybdenum oxyhalide with a high yield of 90% or higher.

Various and beneficial advantages and effects in the present disclosure are not limited to the above description, and may be more easily understood in the course of describing the specific example embodiments in the present disclosure.

### Brief Description of Drawings

FIG. 1 is a schematic diagram illustrating a production apparatus according to an example embodiment of the present disclosure.
FIG. 2 is a schematic diagram illustrating a production apparatus according to another example embodiment of the present disclosure.
FIG. 3 is a schematic diagram illustrating in detail a front region of a raw material supply unit and a reaction zone in a production apparatus according to still another example embodiment of the present disclosure.
FIG. 4 is another schematic diagram illustrating in detail the front region of the raw material supply unit and the reaction zone in the production apparatus according to yet another example embodiment of the present disclosure.
FIG. 5 is a schematic diagram of the production apparatus according to still another example embodiment of the present disclosure.
FIG. 6 is a schematic diagram of the production apparatus according to still another example embodiment of the present disclosure.
FIG. 7 is a schematic diagram of the production apparatus according to still another example embodiment of the present disclosure.
FIG. 8 is a schematic diagram of the production apparatus according to still another example embodiment of the present disclosure.
FIG. 9 is a detailed schematic diagram illustrating a collection unit, a purification transfer unit, and a purification unit in the production apparatus according to another example embodiment of the present disclosure.
FIG. 10 is a schematic diagram of the production apparatus according to still another example embodiment of the present disclosure.

### Mode for Invention

Hereinafter, example embodiments of the present disclosure will be described with reference to the accompanying drawings. However, the example embodiments of the present disclosure may be modified in many different forms and the scope of the present disclosure should not be limited to the example embodiments set forth herein.

In addition, the example embodiments of the present disclosure are provided to more fully explain the present disclosure to those skilled in the art.

In the accompanying drawings, shapes and dimensions of components may be exaggerated for clarity.

In description of example embodiments of the present disclosure, well-known technologies are not described in detail not to obscure the description of the present disclosure with unnecessary detail. Further, the following terminologies are defined in consideration of the functions in the present disclosure and may be construed in different ways by the intention of users and operators. Therefore, the definitions thereof should be construed based on the contents throughout the specification. The terms used in the detailed description is merely for describing the example embodiments of the present disclosure and should in no way be limited. Unless clearly used otherwise, an expression in the singular form includes the meaning of the plural form.

In this description, expressions such as "including" or "comprising" are intended to indicate certain characteristics, numbers, steps, operations, elements, some or combinations thereof, and it should not be interpreted to exclude the existence or possibility of one or more other characteristics, numbers, steps, operations, elements, parts or combinations thereof other than those described.

Unless otherwise specified in the present specification, the unit '%' means weight%.

In this specification and the appended claims, terms such as first, second, etc., are used for the purpose of distinguishing one component from another component, not in a limiting sense.

A case in which any one part is connected with the other part includes a case in which the parts are directly connected with each other and a case in which the parts are indirectly connected with each other with other elements interposed therebetween.

Below, the present disclosure will be described in detail through each example embodiment or example of the present disclosure. It should be noted that each example embodiment or example described in this specification is not limited to one example embodiment or example but may also be combined with other example embodiments or examples. Therefore, the citation of claims in the claim is merely an example of an example embodiment and the technical concept of the present disclosure should not be construed as being solely limited to the combination with the cited claim. Combinations with various claims also fall within the scope of the technical concept of the present disclosure.

Terms used in the present disclosure are to describe the present disclosure, and are not intended to limit the present disclosure. In addition, singular forms used herein include the plural forms unless the relevant definition clearly dictates the contrary.

Unless defined otherwise, all terms including technical terms and scientific terms used herein have the same meaning as commonly understood by a person of ordinary skill in the art to which the present disclosure belongs. The terms defined in the dictionary are interpreted to have a meaning consistent with the related technical literature and the currently disclosed content.

In this specification and the appended claims, molybdenum oxide may, in a material sense, refer to a compound of molybdenum and oxygen. In an example embodiment, molybdenum oxide may include molybdenum dioxide (MoO₂), molybdenum trioxide (MoO₃), MoxOy (x is a real number of 4 to 18 and y is a real number of 11 to 47, in accordance with a stoichiometric ratio), or a mixture thereof. Substantial examples of MoₓO_{y} include, but are not limited to, Mo₄O₁₁, Mo₁₈O₅₂, Mo₅O₁₄, Mo₁₄O₄₇, or mixtures thereof. In this case, the chemical formulas set forth, such as MoO₂ and MoO₃, should not be construed as strictly indicating a bonding ratio between molybdenum and oxygen in a mathematically strict sense. As is well known, depending on a thermal history experienced by molybdenum oxide, the molybdenum oxide may be in an oxygen-deficient state, and the molybdenum oxide may include MoO₂, MoO₃, or MoxOy (x is a real number of 4 to 18 and y is a real number of 11 to 47), each in an oxygen-deficient state, or a mixture thereof. Crystallographically, molybdenum oxide may be in an amorphous phase, a crystalline phase including a polycrystalline phase or a single-crystal phase, or a composite phase in which an amorphous phase and a crystalline phase coexist. Molybdenum oxide may have a purity of 3N to 5N, but is not limited thereto.

In this specification and the appended claims, a halogen-containing gas may refer to a gaseous substance including a functional group containing a halogen or a moiety containing a halogen, or a gas including a gaseous halogen (Hal₂(g), where Hal is one or more selected from the group consisting of Cl, Br, I, and F). In an example embodiment, the halogen-containing gas may include a halogen gas alone or a mixed gas of a halogen gas and an inert gas. In this case, the halogen gas may include a chlorine gas, a bromine gas, an iodine gas, a fluorine gas, or a mixed gas thereof. The purity of gaseous halogen may be 4N to 5N, but is not limited thereto. When supplying a mixed gas, the mixed gas may include 10 to 90 volume% of inert gas (10 to 90 volume% of halogen-containing gas), specifically 20 to 80 volume% of inert gas (20 to 80 volume% of halogen-containing gas), but is not limited thereto.

In this specification and the appended claims, molybdenum oxyhalide may be a material selected from the group consisting of one or more of molybdenum oxydihalide (MoOHal₂, Hal=halogen), molybdenum oxytrihalide (MoOHal₃, Hal=halogen), molybdenum oxytetrahalide (MoOHal₄, Hal=halogen), and molybdenum dioxydihalide (MoO₂Hal₂, Hal=halogen). As a practical example, the molybdenum oxyhalide may be molybdenum oxychloride that satisfies deposition characteristics required for semiconductor wiring and may be used as a precursor for depositing molybdenum metal. The molybdenum oxychloride may be a material selected from the group consisting of one or more of molybdenum oxydichloride, molybdenum oxytrichloride, molybdenum oxytetrachloride, and molybdenum dioxydichloride.

In the present specification and the appended claims, unless otherwise specified, the term "continuous" may be defined with reference to the synthesis (production) of the molybdenum oxyhalide. Specifically, the molybdenum oxyhalide may be synthesized by a reaction between the molybdenum oxide and the halogen in the halogen-containing gas. The "continuous" may mean that fresh molybdenum oxide is supplied to the synthesis space before the molybdenum oxide present in the space where the molybdenum oxyhalide is synthesized is completely consumed, and fresh halogen-containing gas is supplied to the synthesis space before the halogen in the halogen-containing gas present in the synthesis space is completely consumed. In this case, the "complete consumption" may mean a state in which no further product is substantially produced due to the reactants used in the synthesis, even though the synthesis conditions (temperature, pressure, etc.) of the synthesis space are not changed.

From an experimental perspective based on the flow of time, the "continuous" may mean that an average transfer speed (Va) of a raw material passing through the reaction zone is 0.01 m/hr or greater. In this case, the "average" transfer speed may be calculated according to the equation Va = L / (T2 - T1), using the length L of the reaction zone through which the raw material passes, and the time difference between the time T1 when a raw material is introduced into the reaction zone and the time T2 when the raw material exits (is discharged from) the reaction zone. Accordingly, as long as the average transfer speed is satisfied, not only a case in which the raw material is continuously supplied and the raw material passing through the reaction zone is continuously discharged, but also a case in which the raw material passes through the reaction zone with repeated transfer and intermittent stopping (transfer stoppage) within the reaction zone should be interpreted as continuous. In this case, the transfer of the raw material satisfying the above-described "average" transfer speed means, of course, that the raw material is supplied to the reaction zone so that transfer at the above-described "average" transfer speed is continuously maintained. In practice, the average transfer speed of the raw material may be calculated by introducing an inert material (e.g., glass or quartz), which does not react with the halogen-containing gas and is distinguishable from the raw material, into the reaction zone together with the raw material, and measuring the time required for the introduced inert material to be discharged.

From a temporal point-based experimental perspective, the "continuous" may mean that the supply of the raw material to the reaction zone and the solid-phase collection for recovery of the molybdenum oxyhalide produced in the reaction zone occur simultaneously. The supply of the raw material to the reaction zone and the solid-phase collection of the molybdenum oxyhalide may be simultaneously implemented by continuous synthesis (production) of the molybdenum oxyhalide in the reaction zone.

In the present specification and the appended claims, "the raw material passes through the reaction zone" is a description based on the raw material, which is a material introduced into the reaction zone, and does not mean that the raw material passes through the reaction zone and is discharged in the same state as introduced into the reaction zone. "The raw material passes through the reaction zone" may refer to a series of processes in which a raw material is introduced into the reaction zone, the introduced raw material is transferred within the reaction zone, a reaction occurs to produce the molybdenum oxyhalide, and a residual solid phase is discharged from inside the reaction zone to outside the reaction zone. In this case, the residual solid phase may include solid byproducts produced by the reaction, a residual raw material, or a mixture thereof.

According to an aspect of the present disclosure, an apparatus I for producing molybdenum oxyhalide includes a reaction zone to which a halogen-containing gas is supplied, in which a raw material containing molybdenum oxide is transferred so as to pass through the reaction zone, and molybdenum oxyhalide is produced.

In the production apparatus I according to an example embodiment, as a raw material containing molybdenum oxide is transferred so as to pass through the reaction zone, a fresh raw material may be supplied to the reaction zone before the molybdenum oxide is completely consumed in the reaction zone. Accordingly, the continuous supply of the raw material to the reaction zone is possible. By supplying the raw material, the raw material is continuously transferred in the reaction zone, and the molybdenum oxyhalide may be continuously produced.

Described differently in terms of the continuous production of the molybdenum oxyhalide, the production apparatus I includes a reaction zone to which the halogen-containing gas is supplied, and a raw material containing molybdenum oxide is continuously supplied to the reaction zone and continuously transferred so as to pass through the reaction zone, thereby producing the molybdenum oxyhalide. In this case, the halogen-containing gas may also be continuously supplied to the reaction zone.

In an example embodiment, energy may be applied to the reaction zone. The energy application is intended to provide the activation energy required for the synthesis of the molybdenum oxyhalide, and any energy that enables the production of the desired the molybdenum oxyhalide from the reactant(s) of the halogen-containing gas and the raw material containing molybdenum oxide may be used.

In an example embodiment, at least one energy selected from the group consisting of thermal energy, light energy, and vibrational energy may be applied to the reaction zone, the halogen-containing gas substantially positioned in the reaction zone, and the raw material.

The thermal energy may include Joule heat. The heat source may be positioned inside the reaction zone, outside the reaction zone, or both inside and outside the reaction zone. When positioned outside the reaction zone, the heat source may be in direct contact with the case (outer surface of the case) partitioning the space containing the reaction zone, or may be in indirect contact therewith through a refractory material. When the heat source is positioned inside the reaction zone, the heat source may be positioned in contact with the case (inner surface of the case) partitioning the space containing the reaction zone, positioned to be in direct contact with the raw material containing the metal oxide, or positioned so that heat is applied indirectly to the raw material by a gaseous heat transfer medium. The direct contact between the raw material and the heat source may include cases in which the transfer means provided to transfer the raw material is itself the heat source, in which the heat source is provided inside the transfer means, or in which the heat source heats the transfer means such that the transfer means acts as a heat transfer medium.

The light of the light energy may include thermal radiation, and the thermal radiation may include infrared to near-infrared rays. The application of the light energy may include irradiation of light. The light source may be positioned inside the reaction zone, outside the reaction zone, or both inside and outside the reaction zone. As a non-limiting example, the energy application may be achieved by irradiating the raw material with light using an infrared to near-infrared light source positioned inside the reaction zone at a certain distance from the raw material.

The vibration of the vibrational energy may include microwaves, ultrasound, or microwaves and ultrasound. The application of the vibrational energy may include irradiation of microwaves and/or ultrasound. As a non-limiting example, the energy application may be achieved by irradiating the raw material with microwaves and/or ultrasound using a microwave and/or ultrasound source positioned at a certain distance from the raw material.

When applying energy, different types of energy may be applied to the raw material simultaneously or at different points in time (based on a single raw material being transferred). For example, the light energy may be applied simultaneously with the thermal energy being applied to the reaction zone. As another example, the thermal energy is applied to the reaction zone, and a region in which the light energy is applied and a region in which the light energy is not applied are formed within the reaction zone, and the raw material passes through the reaction zone by passing through both the region in which the thermal energy is applied and the region in which thermal energy and light energy are simultaneously applied.

As described above, the production apparatus I may include a case that partitions a space (internal space) including the reaction zone and an energy application unit that applies energy to the reaction zone.

The case partitions an internal space where molybdenum oxyhalide is produced, and the halogen-containing gas is supplied to at least a portion of the internal space provided by the case, and the reaction zone may be formed.

The energy application unit may apply at least one energy selected from the group consisting of thermal energy, light energy, and vibrational energy described above to the reaction zone.

In addition, the production apparatus I may include a transfer means for transferring the raw material to pass through the reaction zone. The transfer means may be positioned inside the reaction zone. The statement that the transfer means is positioned within the reaction zone may mean that, at least, a moving part for transferring the raw material, in which the raw material is positioned in the transfer means, is positioned within the reaction zone. Connecting parts for connecting to a power source for driving the transfer means, or fixing parts for fixing the transfer means, may be positioned within or outside the reaction zone.

The transfer means may be any means commonly used to transfer powder in a predetermined direction. As a non-limiting example, the transfer means may include a transfer shaft rotatably equipped with a transfer blade. Alternatively, the transfer means may include a belt moving in a predetermined direction. In this case, the designed direction may be a linear direction, but is not necessarily limited thereto. A representative example of the transfer means including the transfer shaft rotatably equipped with the transfer blade is a screw conveyor, and a representative example of the transfer means including a belt moving in the designed direction is a belt conveyor.

Hereinafter, the production apparatus I according to an example embodiment will be described in detail with reference to the drawings.

In the drawings, the transfer means including the transfer shaft rotatably equipped with the transfer blade is illustrated, but the present disclosure is not limited to specific types of transfer means. However, when the transfer means includes the transfer shaft rotatably equipped with a transfer blade, the raw material is physically rotated, dropped, mixed, and moved by the transfer blade, thereby allowing smooth and homogeneous contact with the halogen-containing gas even when a large amount of raw material is being transferred, which is more practical.

In addition, although the drawings are illustrated on the assumption that the energy application unit applies heat, the present disclosure is not limited by the type of energy applied. However, among the energies described above, providing activation energy by the thermal energy is more practical, because uniform energy can be applied to the raw material even when a large amount of raw material is supplied, and constant energy may be easily applied to the raw material being transferred even when a path of the reaction zone through which the raw material passes is long. Hereinafter, the energy application unit applying the thermal energy is collectively referred to as a case heating unit.

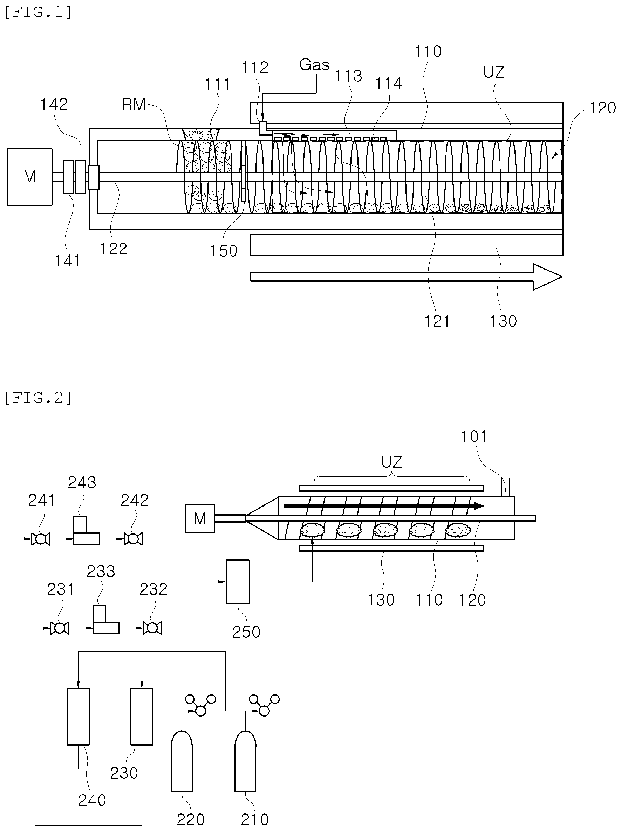

FIG. 1 is a schematic diagram illustrating a production apparatus I according to an example embodiment, comprising a case 110 providing an internal space including a reaction zone UZ, a case heating unit 130 for heating at least a portion of the case 110, and a transfer means 120.

A raw material RM may react with a halogen-containing gas supplied in the reaction zone UZ, and gaseous molybdenum oxyhalide may be produced by this reaction. As the raw material RM continuously passes through the reaction zone UZ, molybdenum oxyhalide may be continuously produced in the reaction zone UZ.

In an example embodiment, the case 110 may be cylindrical or polygonal so that the raw material RM may be transferred in a straight line and pass through the reaction zone UZ, but the present disclosure is not limited by the specific shape of the case 110 and the internal space provided by the case 110.

An internal space for synthesis (production) of the molybdenum oxyhalide may be partitioned by the case 110. A halogen gas may be supplied to at least a portion of the internal space partitioned by the case 110, and the reaction zone UZ in which the halogen gas is present may be formed. A region of the case 110 heated by the case heating unit 130 may include the reaction zone UZ. Alternatively, the reaction zone UZ may include the region of the case 110 heated by the case heating unit 130.

As a non-limiting example, the reaction zone UZ may be the region in the internal space where the halogen-containing gas is supplied and is heated by the case heating unit 130. Specifically, the reaction zone UZ may include a uniform zone. As an example, the reaction zone UZ may be the same as the uniform zone. The uniform zone is a section where temperature is maintained substantially constant regardless of specific location within the region. The temperature (temperature of the uniform zone) of the reaction zone UZ may be the reaction temperature (synthesis temperature, Trx, °C) at which the molybdenum oxide reacts with the halogen-containing gas to synthesize the molybdenum oxyhalide.

The uniform zone may be formed by a case heating unit 130 that heats at least a portion of the case 110, and a length of the uniform zone may be controlled by the length of a portion of the case 110 heated by the case heating unit 130. The case heating unit 130 may be positioned on an upper portion, a lower portion, and/or a side portion of a desired region of the case 110, or may be positioned to surround the desired region of the case 110.

In the case 110, a supply port 111 for receiving the raw material RM may be formed in a front side, specifically in a region between a front end portion of the case 110 and a starting point of the reaction zone UZ, with respect to a transfer direction (indicated by an arrow in FIG. 1) of the raw material RM. In this case, the raw material RM supplied through the supply port 111 may be transferred to a rear end portion side of the case 110 while passing through the reaction zone UZ by the transfer means 120. The raw material continuously supplied from the supply port 111 may continuously pass through the reaction zone UZ by the transfer means 120.

Although FIG. 1 illustrates an example in which one supply port 111 is positioned in the front side, two or more supply ports may be formed to be spaced apart along a transfer path of the raw material RM, and the raw material may be supplied through each supply port. If necessary, at least some of the two or more supply ports may be positioned in a region in which the reaction zone UZ is formed.

The transfer means 120 may transfer the raw material RM so as to pass through the reaction zone UZ to which the halogen-containing gas is supplied. The transfer means 120 may transfer the raw material RM from one end side of the case 110 to the other end side of the case 110 inside the case 110.

As in an example embodiment of FIG. 1, the transfer means 120 may include a transfer shaft 122 that is rotatably provided and has a transfer blade 121. For clearer recognition in the schematic diagram of FIG. 1, the transfer blade 121 is indicated by a line. The transfer shaft 122 having the transfer blade 121 may be positioned inside the case 110.

The transfer shaft 122 having the transfer blade 121 may be fixed by a magnetic coupling and may be rotated by a rotating magnetic field. In detail, as illustrated in FIG. 1, the transfer means 120 may include a driving magnet 141 and a rotating magnet 142 formed to cross at 90° with the driving magnet 141 at a predetermined interval, and the rotating magnet 142 may rotate by attraction and repulsion forces generated between the rotating magnet 142 and the driving magnet 141. The transfer shaft 122 may be connected (fixed) to the rotating magnet 142 so as to rotate integrally when the rotating magnet 142 rotates.

By rotation of the transfer shaft 122, which is rotatably provided with the transfer blade 121, the raw material RM supplied through the supply port 111 may be transferred so as to pass through the reaction zone UZ.

If necessary, the transfer blade 121 may have a porous structure. A smoother flow of the halogen-containing gas and the gaseous molybdenum oxyhalide within the reaction zone UZ may be ensured by the porous transfer blade. The porous structure may be formed by providing through-holes penetrating the transfer blade in a thickness direction, or by the blade itself having a porous network structure such as a mesh. The porosity of the transfer blade may be defined as a ratio of an area occupied by pores to an area of a blade surface. The porosity of each transfer blade may be the same, or may increase or decrease depending on the transfer direction of the raw material RM. It goes without saying that the transfer blade 121 may also have a non-porous structure.

The halogen-containing gas may be introduced into a region where the reaction zone UZ begins, specifically, into a region having a temperature of Trx-50°C to Trx in the case when a temperature of the reaction zone UZ is Trx (°C). A gas inlet 112 through which the halogen-containing gas is introduced may be positioned in the region where the reaction zone UZ begins. In order to suppress temperature fluctuation inside the reaction zone UZ due to the introduction of the halogen-containing gas and to allow the raw material and the halogen-containing gas to more smoothly come into contact at the introduction point of the halogen-containing gas, the halogen-containing gas may be introduced by a sprayer.

In an example embodiment, the sprayer may include the gas inlet 112, a flow path 113 through which gas introduced into the gas inlet 112 flows, and a spray nozzle 114 communicating with the flow path 113 to disperse the halogen-containing gas into the internal space. The sprayer may be provided integrally with the case 110 or may be provided as a separate unit from the case 110. In this case, when the sprayer is provided integrally with the case, at least the spray nozzle 114 may have a structure extending from a wall of an adjacent case 110, thereby allowing the internal space partitioned by the case 110 to maintain a sealed state. When the sprayer is provided as a separate unit from the case, a wall of the case 110 in contact with the sprayer may be a porous wall provided with through-holes through which the dispersed halogen-containing gas may be introduced. In this case, the through-holes of the porous wall may be directly communicated with the flow path 113 of the sprayer, such that a region of the wall of the case 110 in which the through-holes are formed may perform a role of the spray nozzle.

The sprayer may be positioned at an upper portion of the region where the reaction zone UZ begins, as in an example of FIG. 1, or may be positioned at one or more selected from among an upper portion, a lower portion, and a side portion of the region where the reaction zone UZ begins, or may be formed to surround the region where the reaction zone UZ begins, but is not limited thereto.

In addition, although FIG. 1 illustrates an example in which a single sprayer is positioned at a point where the reaction zone UZ begins, two or more sprayers may be spaced apart along the transfer path of the raw material RM, and the halogen-containing gas may be supplied to each sprayer. The two or more sprayers may each be positioned in a region where the reaction zone UZ is formed.

In the internal space, a partition wall 150 for preventing gas backflow may be provided upstream of an inlet point at which the halogen-containing gas is introduced, based on the transfer direction of the raw material. In detail, the partition wall 150 may be positioned between the supply port 111 configured to receive the raw material RM and the halogen-containing gas inlet 112. To prevent gas backflow and ensure smooth transfer of the raw material by the transfer blade, the partition wall 150 provided in the case 110 may be configured to seal at least an upper portion of the transfer shaft 122 with respect to the transfer shaft 122, while leaving at least a portion of a lower portion of the transfer shaft 122 open.

The halogen-containing gas may be a mixed gas of a halogen gas and a carrier inert gas (e.g., nitrogen, argon, neon, helium, etc.). A purity of each of the halogen gas and the inert gas may be 4N to 5N, but is not limited thereto.

The case 110 may include a first outlet 101 (see FIG. 2) positioned in a region where the reaction zone UZ ends. A gas phase containing synthesized molybdenum oxyhalide may be discharged through the first outlet 101. The first outlet 101 may be formed at any position where smooth discharge of the gas phase is enabled; for example, the first outlet 101 may be positioned on an upper side of a rear region, which is a region between a point where the reaction zone UZ ends and a rear end of the case 110, based on the transfer direction of the raw material.

Injection conditions of the halogen-containing gas, the temperature of the reaction zone, the length of the reaction zone, the transfer speed of the raw material passing through the reaction zone, etc., may be determined in consideration of a specific material of desired molybdenum oxyhalide.

Hereinafter, specific conditions for continuous synthesis of molybdenum oxyhalide are provided, particularly conditions advantageous for continuous synthesis of the molybdenum dioxydichloride.

When continuously synthesizing the molybdenum dioxydichloride, which is useful as a precursor for depositing molybdenum metal, it is desirable to synthesize molybdenum dioxydichloride by performing a reaction under a high concentration of halogen at a temperature lower than a reaction temperature typically used in batch synthesis.

The raw material may be particulate molybdenum oxide, substantially particulate molybdenum dioxide. In this case, a particle size thereof may be in a range of tens of micrometers to tens of millimeters, substantially 100 µm to 5 mm, more specifically 100 µm to 2 mm, in terms of providing a wider contact area with the halogen-containing gas and smooth flowability, but is not limited thereto. The particles of molybdenum dioxide may be not only polycrystalline particles, but also granules in which a plurality of particles are agglomerated, or may be molded bodies formed by shaping powdered molybdenum dioxide into a desired size and shape. The molybdenum dioxide may have a purity of 3N to 5N, but is not limited thereto.

The temperature Trx of the reaction zone UZ may be 190 to 350°C, preferably 200 to 300°C, more preferably 200 to 250°C, and still more preferably 200 to 220°C.

The halogen-containing gas may be supplied to the reaction zone such that, based on a reference mole defined as the number of moles of halogen atoms required to produce 1 mole of molybdenum oxyhalide according to a stoichiometric ratio thereof, 1 to 10 times, specifically 2 to 5 times, and more specifically 2 to 3 times the reference mole of halogen elements is supplied. In other words, when n_{MO} moles of molybdenum oxide and nₕₐₗ moles (reference number moles) of halogen atoms are required to produce 1 mole of molybdenum oxyhalide according to the stoichiometric ratio thereof, the halogen-containing gas may be supplied to the reaction zone such that nₕₐₗ to 10nₕₐₗ moles of halogen elements (halogen atoms) are supplied. Accordingly, when kn_{MO} moles of a raw material containing molybdenum oxide are supplied to the reaction zone per unit time, the halogen-containing gas may be supplied to the reaction zone such that knₕₐₗ to 10knₕₐₗ moles of halogen elements are supplied per unit time. In this case, k is a positive real number and may be determined according to a production capacity of molybdenum oxyhalide of the apparatus, which is a design value. As a practical example, when the molybdenum oxide is the molybdenum dioxide and the molybdenum dioxydichloride is to be prepared, n_{MO} is 1 mole and nₕₐₗ is 2 moles, and the halogen-containing gas may be supplied to the reaction zone such that 2 to 20 moles of halogen elements (halogen atoms) are supplied when 1 mole of molybdenum dioxide is supplied.

When the raw material passes through the reaction zone without interruption by the transfer means, the transfer speed of the raw material may be 0.01 m/hr to 10.00 m/hr, preferably 0.01 m/hr to 5.00 m/hr, more preferably 0.10 m/hr to 1.00 m/hr, and still more preferably 0.30 m/hr to 0.90 m/hr. In combination with this, or independently thereof, an average transfer speed of the raw material may be 0.01 m/hr to 10.00 m/hr.

Based on the raw material transfer speed described above, the reaction zone UZ may have a length such that it takes 10 to 600 minutes, preferably 60 to 300 minutes, and more preferably 60 to 180 minutes for the raw material to pass through the reaction zone UZ.

As the raw material is continuously supplied to the reaction zone, the halogen-containing gas may also be continuously supplied to the reaction zone, preferably so as to satisfy the supply amount of the halogen elements of nₕₐₗ to 10nₕₐₗ described above. The gaseous molybdenum oxyhalide synthesized in the reaction zone may be carried by a halogen-containing gas, more specifically by an inert gas contained in the halogen-containing gas, and may continuously flow toward a rear end of the reaction zone and be continuously discharged outside the reaction zone.

FIG. 2 is a schematic diagram illustrating the production apparatus I according to another example embodiment of the present disclosure. As illustrated in FIG. 2, the production apparatus may include a first gas supply unit and a second gas supply unit. The first gas supply unit may include a first gas cylinder 210 in which the halogen gas is stored and a first moisture adsorber 230, and the second gas supply unit may include a second gas cylinder 220 in which the inert gas is stored and a second moisture adsorber 240.

In the first gas supply unit for supplying the halogen gas to the reaction zone UZ, the halogen gas discharged from the first gas cylinder 210 may pass through the first moisture adsorber 230 and be supplied to the reaction zone with moisture removed.

In the second gas supply unit for supplying the inert gas, which is a carrier gas, to the reaction zone, the inert gas discharged from the second gas cylinder 220 in which an inert gas is stored may pass through the second moisture adsorber 240 and be supplied to the reaction zone with moisture removed.

Each of the first moisture adsorber 230 and the second moisture adsorber 240 may be provided with a moisture adsorbent, so that the moisture in the gas may be removed by adsorption. In this case, the moisture adsorbent may be provided in the form of a column or a module, and may be configured as a replaceable type.

FIG. 2 illustrates an example in which a single moisture adsorber is provided for each gas supply unit, but the present disclosure is not limited thereto. Two or more moisture adsorbers may be provided for each gas supply unit. The first gas supply unit may include two or more first moisture adsorbers connected to the first gas cylinder 210, and/or the second gas supply unit may include two or more second moisture adsorbers connected to the second gas cylinder 220. In this case, the two or more moisture adsorbers connected to the same gas cylinder may be used alternately and selectively. Accordingly, when replacement or regeneration of the adsorbent in the moisture adsorber to which a gas is supplied is required, gas may be supplied to another moisture adsorber not in use, thereby removing moisture from the gas and enabling continuous supply of moisture-removed gas to the reaction zone without interruption.

The halogen-containing gas continuously supplied to the reaction zone may have a notable influence on a degree of moisture contamination of the continuously synthesized molybdenum oxyhalide. As illustrated in FIG. 2, the halogen gas and the inert gas from which the moisture has been removed by the moisture adsorbers 230 and 240 may be mixed to form a halogen-containing gas stream, and the halogen-containing gas stream may undergo secondary moisture removal by a gas purifier 250 positioned upstream of the gas inlet 112. The gas purifier 250 may remove moisture not removed by the moisture adsorbers 230 and 240 and/or moisture contaminated during passing through a gas flow path, thereby supplying substantially moisture-free halogen-containing gas to the reaction zone. The gas purifier 250 may be a purifier capable of reducing the moisture in the gas to a level of 1 ppm or less, for example through a solvent trap. Unlike the example embodiment illustrated in FIG. 2, the pure halogen gas from which the moisture has been removed by the moisture adsorbers and the gas purifier may be supplied to the reaction zone as the halogen-containing gas. By the moisture adsorbers and the gas purifier, the moisture content of the halogen-containing gas may be controlled to 1 mass ppm or less.

The production apparatus may further include conventional valves 231, 232, 241, and 242 for controlling gas flow (paths), mass flow controllers (MFCs) 233 and 243 for controlling gas flow rates, and a pump for gas transfer.

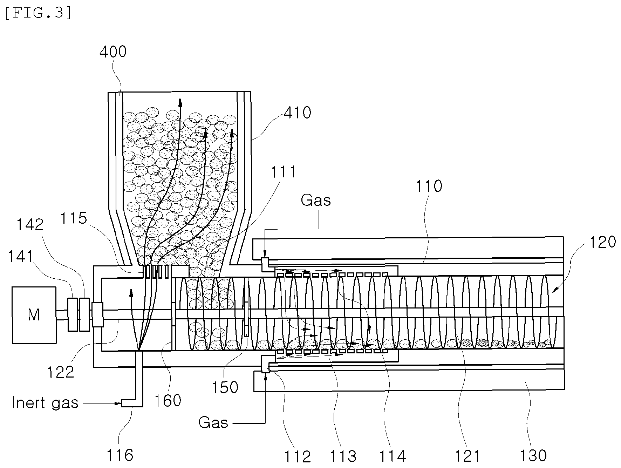

FIG. 3 is a detailed schematic diagram of the production apparatus I according to an example embodiment, specifically illustrating in detail a front region of the raw material supply unit and the reaction zone. As illustrated in FIG. 3, the production apparatus I may further include a raw material supply unit 400 and a raw material heating unit 410 for heating the raw material supply unit 400. The raw material stored in the raw material supply unit 400 may be heated by the raw material heating unit 410 so that the moisture adsorbed on the raw material may be desorbed and removed. A temperature at which the raw material is heated by the raw material heating unit 410 may be 100 to 250°C, specifically 100 to 200°C, but is not limited thereto, and any temperature at which effective moisture removal is achieved may be used.

The supply port 111 of the case 110 may be connected in communication with the raw material supply unit 400, so that the raw material stored in the raw material supply unit 400 may be introduced into the internal space of the case 110 through the supply port 111, and the introduced raw material may be transferred by the transfer blade 121 and supplied to the reaction zone UZ.

As illustrated in FIG. 3, the inert gas, preferably an inert gas from which moisture has been removed, may be supplied to the raw material supply unit 400. For more effective moisture removal from the raw material, it is preferable that the inert gas be introduced into a lower portion of the raw material supply unit 400.

To this end, a sealing wall 160 partitioning an internal space of the case 110 may be positioned upstream of the supply port 111, based on the transfer direction of the raw material. The second gas inlet 116 for introducing the inert gas may be provided in a front region of the case 110, which is a space between a front end portion of the case 110 and the sealing wall 160. A wall of the case 110 adjacent to the raw material supply unit 400 in the front region may be a porous wall provided with through-holes 115 which may be configured to allow communication between the front region and the internal space of the raw material supply unit 400.

In this case, the inert gas supplied to the second gas inlet 116 may be an inert gas from which moisture has been removed, supplied from the second gas supply unit. In detail, the inert gas stream passing through the second moisture adsorber 240 may be branched into a first inert gas stream and a second inert gas stream, the first inert gas stream may be mixed with a moisture-removed halogen gas, and the second inert gas stream may be supplied to the raw material supply unit 400 through the second gas inlet 116.

As illustrated in FIG. 3, by supplying the inert gas from which the moisture has been removed through the lower portion of the raw material supply unit 400, more rapid removal of moisture from the raw material may be achieved, and re-contamination with moisture of the raw material positioned in a lower region of the raw material supply unit 400 immediately before being supplied to the supply port 111 may be effectively prevented. In this case, the raw material supply unit 400 may further include a vent port (not illustrated) through which a gas phase containing moisture desorbed from the raw material is discharged. As described above, the raw material from which the moisture has been removed may be supplied to the reaction zone, and in this case, a moisture content of the raw material may be controlled to tens to hundreds of mass ppm, and specifically 10 to 500 mass ppm.

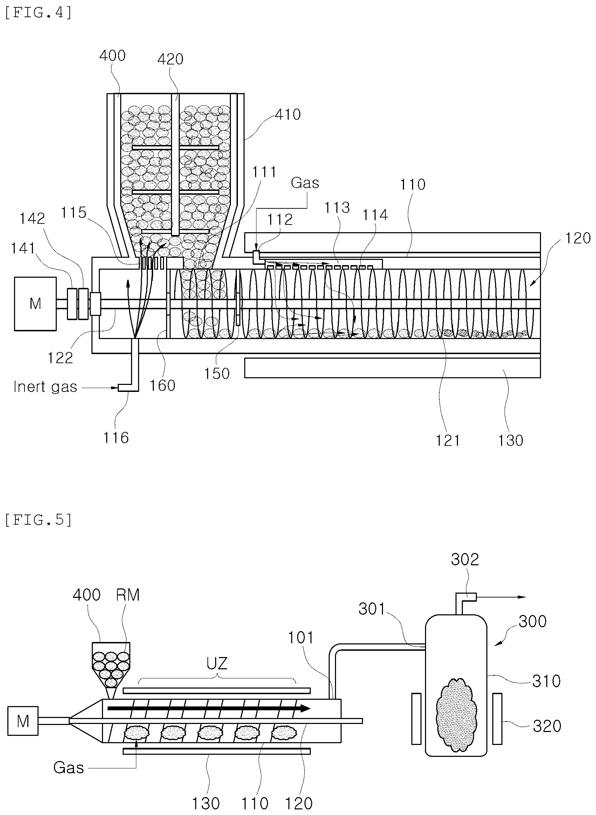

FIG. 4 is a detailed schematic diagram of the production apparatus I according to an example embodiment, and more specifically, another schematic diagram illustrating in detail a front region of a raw material supply unit and a reaction zone. As illustrated in FIG. 4, the raw material supply unit 400 may further include a stirrer 420. By further providing the stirrer 420 in the raw material supply unit 400, the raw material may be supplied more smoothly to the supply port 111, and, in addition, the raw material may be brought into more smooth and uniform contact with an inert gas introduced from a lower portion of the raw material supply unit 400, thereby enabling faster and more homogeneous moisture removal.

The stirrer 420 may include a rotating shaft and blades coupled to the rotating shaft. Examples of specific shapes and structures of the blade may include straight blades, open turbine blades, propeller blades, disc turbine blades, anchor blades, ribbon blades, helical blades, or combinations thereof, but are not limited thereto. In one example of FIG. 4, the straight blades are radially coupled to the rotating shaft, and the radially combined blades form blade arrays, in which three blade arrays are spaced apart from each other in an axial direction of the rotating shaft. However, the specific structure and shape of the blades are not limited, and any configuration may be adopted as long as it induces flow of the raw material without obstructing the flow of inert gas.

FIG. 5 is a schematic diagram of a production apparatus I according to another example embodiment, in which the production apparatus further includes a collection unit 300. Gas discharged through the first outlet 101 described above may be introduced into the collection unit 300 through the first inlet 301. The collection unit 300 may cool the gas introduced through the first inlet 301 to collect gaseous molybdenum oxyhalide in a solid state.

The collection unit 300 may include a collection body 310 having an internal space configured to receive the gas introduced through the first inlet 301, and a first cooling unit 320 configured to cool the introduced gas. The gaseous molybdenum oxyhalide continuously synthesized in the reaction zone UZ is continuously discharged through the first outlet 101 of the case 110, and accordingly, the gaseous molybdenum oxyhalide is continuously introduced into the collection unit 300 through the first inlet 301 and cooled by the first cooling unit 320, thereby continuously solidifying the molybdenum oxyhalide.

To ensure smooth inflow, a residual gas phase remaining after the molybdenum oxyhalide is collected by solidification may be discharged. Accordingly, if necessary, the collection body 310 may further include a first vent port 302 for discharging the residual gas.

In the collection body 310, the first inlet 301 and the first vent port 302 may be positioned such that smooth gas inflow and smooth discharge of residual gas are achieved. For example, the first inlet 301 may be positioned at an upper side portion of the collection body 310, and the first vent port 302 may be positioned at an upper end portion of the collection body 310, but is not limited thereto.

In the collection unit 300, the first cooling unit 320 may be disposed at a position capable of effectively cooling the gas introduced into the collection body 310. For example, the first cooling unit 320 may be provided at a lower portion and/or a lower side portion of the collection body 310, so that the introduced gas is cooled and solid molybdenum oxyhalide is collected at a lower portion of the collection body 310 by gravity.

A temperature at which the gas phase is cooled by the first cooling unit 320 may be determined depending on the specific material of desired molybdenum oxyhalide. In order to collect the molybdenum dioxydichloride, which is useful as a precursor for depositing molybdenum metal, the first cooling unit 320 may cool the gas introduced into the collection body 310 to 20 to 120°C, preferably 60 to 110°C, and more preferably 90 to 110°C, so as to solidify the continuously introduced molybdenum dioxydichloride. When the molybdenum dioxydichloride is solidified by cooling the gas phase to 90 to 110°C, the density of the collected molybdenum dioxydichloride may be increased to 1 g/L or more, which is advantageous.

In detail, the first cooling unit 320 may form a temperature zone of 20 to 120°C, preferably 60 to 110°C, and more preferably 90 to 110°C, in a region including a lower end portion and a side portion adjacent thereto of the collection body 310. For example, when a height from a lower end portion of the collection body 310 to an upper end portion is defined as H, the region having the temperature set by the first cooling unit 320 may be 0H (lower end portion) to 0.9H, specifically 0H to 0.7H, but is not limited thereto. In this case, the first inlet 301 may be positioned at a side surface or upper surface corresponding to a region of 0.9H to 0.99H.

In an example embodiment, the apparatus may further include a heating unit heating a wall surface that contacts the gaseous molybdenum oxyhalide discharged from the reaction zone and partitions a space used for transferring or storing the gaseous molybdenum oxyhalide.

The heating unit configured to heat the wall surface defining the transfer or storage space may maintain the gaseous molybdenum oxyhalide in a stable gaseous state during transfer or storage, and may also prevent solidification (heterogeneous nucleation and growth) of the molybdenum oxyhalide on the wall surface defining the transfer or storage space.

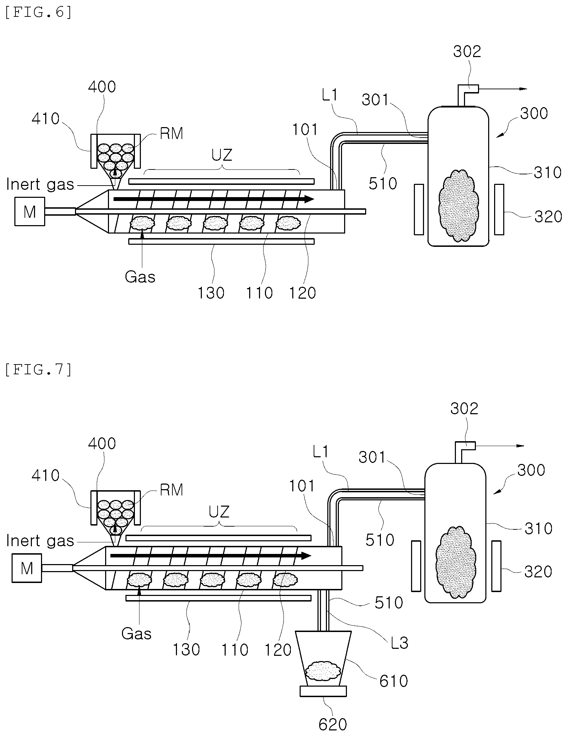

As illustrated in the schematic diagram of the production apparatus I according to another example embodiment illustrated in FIG. 6, the production apparatus I may further include a line heating unit 510 configured to heat a transfer line through which the gaseous molybdenum oxyhalide is transferred. In detail, the line heating unit 510 may heat a first line L1, which is a transfer line between a first outlet 101 through which the gaseous molybdenum oxyhalide produced in the reaction zone UZ is discharged and the first inlet 301 through which the gaseous molybdenum oxyhalide is introduced to the collection unit 300.

By including the line heating unit 510 in the production apparatus I, the solidification of the gaseous molybdenum oxyhalide being transferred on a wall surface of the transfer line is prevented, thereby preventing blockage of the transfer line. In addition, the gaseous molybdenum oxyhalide being transferred may stably maintain a gaseous state, thereby improving the production yield. Furthermore, the contamination of the gaseous molybdenum oxyhalide by moisture may be prevented. To this end, the line heating unit 510 may heat the first line L1 to a temperature of 170 to 230°C, preferably 180 to 220°C, and more preferably 200 to 220°C.

FIG. 7 is a schematic diagram of the production apparatus I according to another example embodiment, in which the production apparatus I may further include a residue storage unit 610 configured to receive and store a residual solid phase discharged from the reaction zone UZ, and a residue heating unit 620 configured to heat the residue storage unit 610.

The residue storage unit 610 may be connected through a third line L3, which is a transfer line between an outlet through which the residual solid phase is discharged to the outside of the case 110 and an inlet through which the residual solid phase is introduced to the residue storage unit 610, or at least a lower portion of a rear side end of the case 110 in the transfer direction of the raw material may be open, such that the residual solid phase may be supplied to the residue storage unit 610 through the open lower portion.

From the gaseous phase perspective, the residue storage unit 610 may be in communication with synthesis parts of the molybdenum oxyhalide, such as the reaction zone UZ or the internal space of the collection body 310. Accordingly, by heating the residue storage unit 610 through the residue heating unit 620, the contamination of the molybdenum oxyhalide by moisture during a synthesis process may be prevented, and at the same time, the unwanted solidification of the molybdenum oxyhalide may be prevented.

When the third line L3 is provided, the line heating unit 510 may also heat the third line L3. By heating the third line L3 by the line heating unit 510, the solidification of the molybdenum oxyhalide on an inner wall of the third line L3 may likewise be prevented.

The residue heating unit 620 and the line heating unit 510 may independently heat the residue storage unit 610 and the third line L3 to a temperature of 170 to 250°C, preferably 180 to 230°C, and more preferably 200 to 220°C. In this case, the residue heating unit 620 and/or the line heating unit 510 may heat the residue storage unit 610 and/or the third line L3 to a temperature higher than the temperature Trx of the reaction zone. Specifically, the residue heating unit 620 may heat the residue storage unit 610 to a temperature higher than Trx to Trx + 50°C, and the line heating unit 510 may, independently or in combination therewith, heat the third line L3 to a temperature higher than Trx to Trx + 50°C. In this case, the gaseous molybdenum oxyhalide discharged from the reaction zone may be effectively prevented from flowing into the residue storage unit 610.

According to another aspect of the present disclosure, an apparatus II for producing molybdenum oxyhalide includes a raw material supply unit supplying a raw material containing molybdenum oxide, a reaction transfer unit including a reaction zone to which a halogen-containing gas is supplied and energy is applied, the raw material supplied from the raw material supply unit being transferred to pass through the reaction zone and molybdenum oxyhalide being generated, a collection unit receiving gaseous molybdenum oxyhalide discharged from the reaction transfer unit and collecting the gaseous molybdenum oxyhalide into a solid phase, a purification unit receiving the solid-phase molybdenum oxyhalide collected in the collection unit and sublimating the received solid-phase molybdenum oxyhalide into a gas, and a solidification unit receiving and solidifying the sublimated molybdenum oxyhalide.

Alternatively, the apparatus II for producing molybdenum oxyhalide according to an example embodiment may further include, in addition to the production apparatus I described above, a purification unit configured to receive solid-phase molybdenum oxyhalide collected in the collection unit and sublimate the received solid-phase molybdenum oxyhalide into a gas; and a solidification unit configured to receive the sublimated molybdenum oxyhalide and solidify the received sublimated molybdenum oxyhalide. Accordingly, the production apparatus II according to an example embodiment includes all features of the production apparatus I described above with reference to FIGS. 1 to 7, and the apparatus including the reaction zone, a case, and transfer means to which the halogen-containing gas is supplied may correspond to the reaction transfer unit.

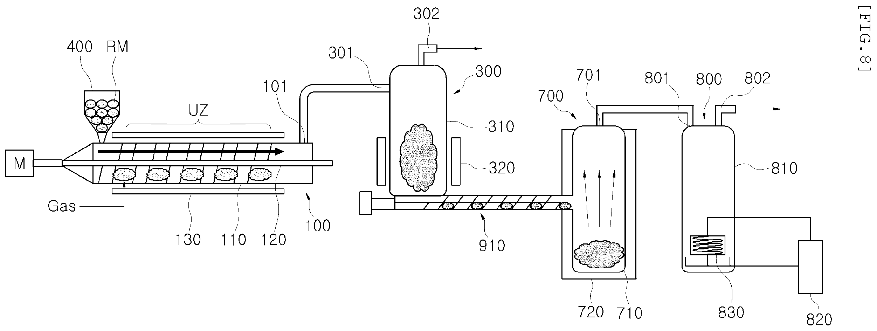

FIG. 8 is a schematic diagram illustrating the production apparatus II according to an example embodiment of the present disclosure. As illustrated in FIG. 8, the apparatus II for producing the molybdenum oxyhalide may include a raw material supply unit 400, a reaction transfer unit 100 including the reaction zone UZ, a collection unit 300, a purification unit 700, and a solidification unit 800.

The raw material supply unit 400 may supply a raw material to the reaction transfer unit 100, and the reaction transfer unit 100 may continuously synthesize the molybdenum oxyhalide by transferring the supplied raw material through the reaction zone. The collection unit 300 may collect the synthesized gaseous molybdenum oxyhalide (g) by phase-transitioning the synthesized gaseous molybdenum oxyhalide (g) into a solid phase, the purification unit 700 may purify the molybdenum oxyhalide by sublimating the collected molybdenum oxyhalide (s) into a gaseous phase, and the solidification unit 800 may produce a final product, the molybdenum oxyhalide (s), by phase-transitioning the sublimated molybdenum oxyhalide (g) back into a solid phase.

The solid molybdenum oxyhalide collected in the collection unit 300 may be transferred to the purification unit 700 through a purification transfer unit 910. In addition, although the collection of the molybdenum oxyhalide in the solid phase is performed continuously in the collection unit 300, the purification transfer unit 910 does not necessarily transfer the continuously collected solid to the purification unit 700. The purification transfer unit 910 may transfer the collected solid to the purification unit 700 either continuously or at regular time intervals, i.e., discontinuously.

The purification unit 700 may sublimate the solid-phase molybdenum oxyhalide (s). The purity of the molybdenum oxyhalide may be improved through purification by sublimation.

The purification unit 700 may include a purification body 710 having an internal space and configured to receive the solid the molybdenum oxyhalide (s) transferred and introduced through the purification transfer unit 910, and a purification heating unit 720 configured to heat the molybdenum oxyhalide (s) received in the purification body 710. The purification heating unit 720 may be positioned at a lower portion and/or side surfaces of the purification body 710 and may surround the upper portion, lower portion, and side surfaces of the purification body 710. If necessary, the purification unit 700 may further include a vacuum exhaust unit (not illustrated) configured to reduce pressure inside the purification body 710. This is because the sublimation temperature of the molybdenum oxyhalide varies depending on pressure.

The internal pressure of the purification body 710 may be controlled to a set pressure by the vacuum exhaust unit (not illustrated), and the molybdenum oxyhalide s contained in the purification body 710 may be heated to the set sublimation temperature by the purification heating unit 720. The sublimated molybdenum oxyhalide (g) from the purification unit 700 may be discharged through a second outlet 701 provided in the purification body 710.

The pressurization conditions (pressure and temperature) may be determined according to the specific material of desired molybdenum oxyhalide. When sublimating the molybdenum dioxydichloride, which is useful as the precursor for depositing the molybdenum metal, the sublimation of the molybdenum dioxydichloride s contained in the purification body 710 may be performed under atmospheric pressure, and the molybdenum dioxydichloride s may be sublimated by heating to a temperature of 170 to 230°C, preferably 180 to 220°C, and more preferably 200 to 220°C by the purification heating unit 720.

The sublimated molybdenum oxyhalide (g) discharged from the purification unit 700 through the second outlet 701 may be introduced into the solidification unit 800. The solidification unit 800 may cool the sublimated molybdenum oxyhalide (g) to produce the molybdenum oxyhalide s which is the final product. That is, the sublimated molybdenum oxyhalide (g) may be re-cooled in the solidification unit 800, solidified therein, and recovered.

The solidification unit 800 may include a solidification body 810 having an internal space configured to receive the sublimated molybdenum oxyhalide (g) gas, and a second cooling unit 820 configured to cool the molybdenum oxyhalide (g) received in the solidification body 810. In this case, a cooling plate 830 cooled by the second cooling unit 820 is provided inside the solidification body 810, such that solidification of the molybdenum oxyhalide occurs around the cooling plate 830.

The solidification body 810 may be provided with a second inlet 801 through which the sublimated molybdenum oxyhalide (g) is introduced and the second vent 802 through which unreacted residual gas is discharged. In this case, the second inlet 801 and the second vent 802 may each be spaced apart from each other and positioned at an upper end portion of the solidification body 810, but are not limited thereto.

The cooling temperature for solidification may be determined according to the specific material of the desired the molybdenum oxyhalide. When the molybdenum dioxydichloride (s), which is the final product, is recovered by the solidification of the molybdenum dioxydichloride, which is useful as the precursor for depositing the molybdenum metal, the cooling temperature (temperature of a cooling plate) by the second cooling unit 820 may be in a range of -30 to 20°C, but is not limited thereto.

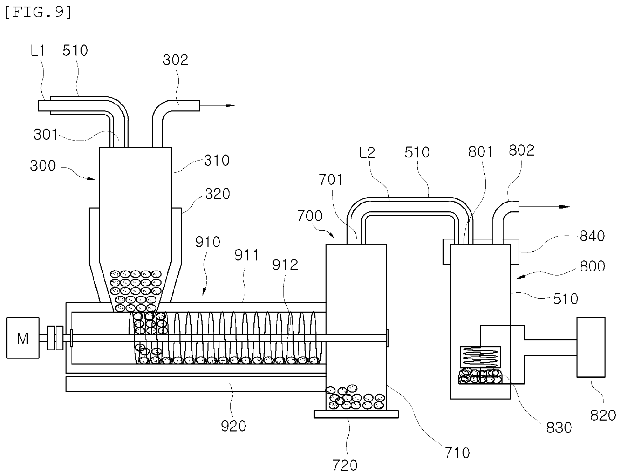

FIG. 9 is a detailed schematic diagram illustrating the collection unit 300, the purification transfer unit 910, the purification unit 700, and the solidification unit 800 in the production apparatus II according to an example embodiment. As illustrated in FIG. 9, the production apparatus II may further include a transfer heating unit 920 configured to heat the purification transfer unit 910. By heating the solid-phase molybdenum oxyhalide transferred through the purification transfer unit 910 by the transfer heating unit 920, contamination due to moisture and the like may be prevented, and the purity of the obtained final product may be improved. The purification transfer unit 910 may be heated by the transfer heating unit 920 to a temperature of 50 to 120°C, specifically 80 to 120°C, and more specifically 100 to 120°C.

One example of FIG. 9 illustrates a screw-type purification transfer unit 910 in which a space through which the solid-phase molybdenum oxyhalide is transferred is partitioned by the case. As illustrated in FIG. 9, the case 911 of the purification transfer unit 910 communicates with to a lower end portion of the collection unit 300 at a front side in the transfer direction, so that the solid-phase molybdenum oxyhalide collected in the collection unit 300 may flow into the purification transfer unit 910. In addition, at least a lower side of a rear end portion of the case 911 of the purification transfer unit 910 in the transfer direction is open, so that the solid-phase molybdenum oxyhalide may be supplied to the purification unit 700 through the open lower side. In this case, as in one example illustrated in FIG. 9, the transfer shaft 912 having blades formed thereon may be fixed by a magnetic coupling and rotated by a rotating magnetic field, and one end (rear end) of the transfer shaft 912 not fixed by the magnetic coupling may be fixed to the purification body 710. The purification transfer unit 910 illustrated in FIG. 9 has a structure capable of minimizing unwanted heat loss during the transfer process; however, the purification transfer unit is not limited to the screw type illustrated in FIG. 9. Any conventional transfer device capable of transferring solid powder in a desired direction within a partitioned space may be used as the purification transfer unit.

As in one example illustrated in FIG. 9, the solidification unit 800 may further include at least a solidification heating unit 840 configured to heat an upper end portion of the solidification body 810 where the second inlet 801 is positioned.

The solidification heating unit 840 may heat the sublimated molybdenum oxyhalide (g) introduced through the second inlet 801 and, together with the second cooling unit 820, form a temperature gradient within the solidification body 810. Due to this temperature gradient, the rapid solidification (crystallization) of the molybdenum oxyhalide may be achieved without blockage of the second line L2 and the second inlet 801.

The solidification heating unit 840 may heat an upper region including the upper end portion of the solidification body 810 to a temperature of 170 to 230°C, preferably 180 to 220°C, and more preferably 200 to 220°C. Accordingly, the temperature gradient may be formed between an upper region having a temperature of 170 to 230°C and the cooling plate positioned in a lower region of the solidification body 810 having a temperature of -30 to 20°C.

Specifically, when a height from the lower portion of the solidification body 810 to the upper end portion is defined as Hc, the cooling plate 830 cooled by the second cooling unit 820 may be positioned in a lower region of the solidification body 810, specifically in a region extending from 0.1 Hc to 0.4 Hc from the lower portion. At the same time, the solidification heating unit 840 may be positioned to heat an upper region, specifically a region extending from 0.6 Hc to 0.9 Hc from the upper end portion. Due to the temperature gradient formed in the height direction of the solidification body 810, a final product of high-purity molybdenum oxyhalide (s) with high yield and reduced contamination may be obtained.

In addition, as in one example illustrated in FIG. 9, the second line L2, which is a transfer line between the second outlet 701 through which the sublimated molybdenum oxyhalide is discharged from the purification unit 700 and the second inlet 801 through which the sublimated molybdenum oxyhalide is introduced into the solidification unit 800, may be heated by the line heating unit 510. By heating the second line L2 using the line heating unit 510, the solidification of the gaseous molybdenum oxyhalide during transfer is prevented, thereby preventing pipe blockage and further preventing moisture contamination. The second line L2 may be heated to a temperature of 170 to 230°C, preferably 180 to 220°C, and more preferably 200 to 220°C by the line heating unit 510, independently of the first line L1 and the third line L3 described above.

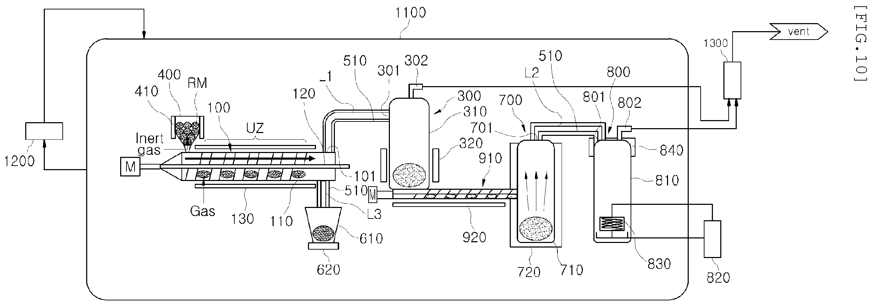

FIG. 10 illustrates a schematic diagram of a production apparatus according to an example embodiment, in which the production apparatus further includes a housing 1100, a moisture removal unit 1200, and a halogen adsorption unit 1300.

The housing 1100 may provide an internal space filled with air, in which at least the raw material supply unit 400, the reaction transfer unit 100, the collection unit 300, the purification unit 700, and the solidification unit 800 are positioned. The moisture removal unit 1200 may remove moisture from air inside the housing 1100. Specifically, the moisture removal unit 1200 may remove moisture from the atmosphere inside the housing so that the interior of the housing is filled with dry air. The housing 1100 may prevent moisture from penetrating a synthesis space even when there is a risk that the synthesis space extending from the raw material supply unit 400 to the reaction transfer unit 100, the collection unit 300, the purification unit 700, and the solidification unit 800 is exposed to ambient air, for example, when additional raw material is supplied to the raw material supply unit 400 or when the molybdenum oxyhalide, which is the final product, produced in the solidification unit 800 is discharged. The moisture concentration of the dry air inside the housing may be 10 mass ppm or less, specifically 5 mass ppm or less, and more specifically 0.1 to 1 mass ppm.

As in an example illustrated in FIG. 10, the production apparatus may further include a halogen adsorption unit 1300 connected to the first vent 302 of the collection body 310 and the second vent 802 of the solidification body 810. Unreacted halogen gas may be present in gas discharged from the collection body 310 and the solidification body 810. The halogen adsorption unit may receive residual gas discharged from the first vent 302 and the second vent 802 and adsorb and remove the unreacted halogen gas contained in the residual gas. In addition, although not illustrated in the drawings, the production apparatus may further include a valve and a vacuum pump provided in a vent line, and when venting is required, residual gas from the collection unit or the solidification unit may be discharged through the vent using the valve and the vacuum pump.

At least a material of part (contact part material) that come into contact with the halogen-containing gas in the reaction transfer unit, including a case of the reaction transfer unit (e.g., a transfer blade, a transfer shaft, a partition wall for preventing gas inflow, a sprayer, etc.), may be a material having chemical resistance to halogen gas. Representative examples of such contact materials include nickel-molybdenum-based alloys including nickel-chromium-iron-molybdenum alloys, nickel-chromium-molybdenum-tungsten alloys, and nickel-chromium-molybdenum alloys; nickel-chromium-based alloys including nickel-chromium-iron-titanium alloys, nickel-chromium-niobium alloys, and nickel-chromium-aluminum alloys; ceramics such as glass, quartz, and alumina; and/or fluorine resins such as polytetrafluoroethylene. Such contact materials may be provided in the form of a coating layer or a base material, so that chemical resistance of the apparatus may be ensured. Commercially available materials may be used for these contact portions, and representative examples include Hastelloy^{®} alloys, Inconel^{®} alloys, and Teflon^{®} products.

The apparatus for producing the molybdenum oxyhalide described above may continuously produce the molybdenum oxyhalide with a purity of 5N or higher, free from moisture contamination, with a production yield superior to that of batch production.

In addition, even although the apparatus for producing the molybdenum oxyhalide is based on a synthesis scheme for producing the molybdenum oxyhalide by reaction of molybdenum oxide with a halogen gas, it may produce the high-purity molybdenum oxyhalide with a production yield of 90% or more even at a low reaction temperature Trx, for example, 200 to 220°C. A production yield of 90% or more is a significantly higher yield than that of a conventional batch-type apparatus for producing the molybdenum oxyhalide.

In addition, the apparatus for producing the molybdenum oxyhalide may produce high-density molybdenum oxyhalide in which the density of both the synthesized molybdenum oxyhalide (the molybdenum oxyhalide collected in the collection unit) and the purified molybdenum oxyhalide (the molybdenum oxyhalide obtained in the solidification unit) is 1.0 g/L or greater.

In addition, the above-described production apparatus may further include a control unit connected to one or more units selected from the transfer means, the case heating unit, the first cooling unit, the purification heating unit, the second cooling unit, the solidification heating unit, the line heating unit, the transfer heating unit, and the residue heating unit, and controlling the respective units, in order to control at least one of the following elements: the transfer speed of the raw material by the transfer means of the reaction transfer unit, the temperature Trx heated by the case heating unit, the temperature cooled by the first cooling unit, the temperature heated by the purification heating unit, the temperature cooled by the second cooling unit, the temperature heated by the solidification heating unit, the temperature of the first, second, and third lines heated by the line heating unit, the temperature heated by the transfer heating unit, and the temperature heated by the residue heating unit.

The present disclosure includes a method for producing molybdenum oxyhalide using the above-described production apparatus. Hereinafter, in describing the method for producing molybdenum oxyhalide, the production method includes all the contents described above in the production apparatus.

According to still another aspect of the present disclosure, a method for producing molybdenum oxyhalide includes passing a raw material containing molybdenum oxide through a reaction zone, supplying a halogen-containing gas to the reaction zone, and generating molybdenum oxyhalide.

The raw material containing molybdenum oxide may be continuously supplied to the reaction zone, and the molybdenum oxyhalide may be continuously produced. When the raw material is continuously supplied, the halogen-containing gas may also be continuously supplied to the reaction zone.

In an example embodiment, at least one energy selected from the group consisting of thermal energy, the light energy, and the vibrational energy may be applied to the reaction zone, and the activation energy required for synthesis of the molybdenum oxyhalide may be provided by such energy application. Preferably, the energy applied to the reaction zone may include thermal energy.

In an example embodiment, the raw material may flow and pass through the reaction zone. The flow of the raw material is advantageous as it enables continuous contact with fresh and abundant halogen-containing gas. When a net transfer direction of the raw material is defined as an x-axis direction, the flow of the raw material may include an x-axis component as well as a z-axis component and a y-axis component perpendicular to the x-axis direction. At any point in time when the particulate raw material is transferred, the x-axis component, the z-axis component, and the y-axis component may be random and different from one another for each particle. However, since the x-axis component is a direction in which net transfer occurs, it may have a magnitude (average value) corresponding to net transfer from a perspective of the entire raw material. Due to this flow, the particulate raw material may be physically rotated, fallen, mixed, and moved. In terms of the device, the flow of the raw material may be generated as the raw material is transferred by rotation of a rotating shaft provided with a transfer blade.

In an example embodiment, the raw material may be in a state in which moisture has been removed in advance before being supplied to the reaction zone. Removal of moisture from the raw material may be performed by application of heat, or by application of heat and a moisture-removed inert gas.

In combination with this or independently thereof, the halogen-containing gas may be a mixed gas of a halogen gas and an inert gas, and the mixed gas may be in a state in which moisture has been removed in advance before being supplied to the reaction zone. Specifically, the removal of moisture from the halogen gas may be performed by adsorption, and moisture removal from the inert gas may be performed by adsorption, and then the two gases may be mixed to form a mixed gas, and the moisture may be removed again from the mixed gas using a solvent trap or the like, and then the mixed gas may be supplied to the reaction zone.

Specific conditions for continuous synthesis of the molybdenum oxyhalide, particularly specific conditions advantageous for continuous synthesis of the molybdenum dioxydichloride, are as follows.

The raw material may be particulate molybdenum oxide, substantially particulate molybdenum dioxide.

The temperature Trx of the reaction zone UZ may be 190 to 350°C, preferably 200 to 300°C, more preferably 200 to 250°C, and still more preferably 200 to 220°C.

When n_{MO} moles of molybdenum oxide and nₕₐₗ moles (reference moles) of halogen atoms are required to produce 1 mole of molybdenum oxyhalide according to a stoichiometric ratio of the molybdenum oxyhalide, the halogen-containing gas may be supplied to the reaction zone so that nₕₐₗ moles to 10 nₕₐₗ moles, specifically 2 nₕₐₗ moles to 5 nₕₐₗ moles, and more specifically 2 nₕₐₗ moles to 3 nₕₐₗ moles of halogen elements (halogen atoms) are supplied. As a practical example, when the molybdenum oxide is the molybdenum dioxide and the molybdenum dioxydichloride is to be produced, n_{MO} is 1 mole and nₕₐₗ is 2 moles, and the halogen-containing gas may be supplied to the reaction zone so that 2 to 20 moles of halogen elements (halogen atoms) are supplied.

When the raw material is continuously supplied to the reaction zone, a transfer speed of the raw material may be 0.01 m/hr to 10.00 m/hr, preferably 0.01 m/hr to 5.00 m/hr, more preferably 0.10 m/hr to 1.00 m/hr, and even more preferably 0.30 m/hr to 0.90 m/hr. In combination with this, or independently thereof, an average transfer speed of the raw material may be 0.01 m/hr to 10.00 m/hr. In combination with this, or independently thereof, an average transfer speed of the raw material may be 0.01 m/hr to 10.00 m/hr.

A time required for the raw material to pass through the reaction zone UZ may be 10 to 600 minutes, preferably 60 to 300 minutes, and more preferably 60 to 180 minutes.

In an example embodiment, the production method may further include cooling the gaseous molybdenum oxyhalide produced in the reaction zone to collect the gaseous molybdenum oxyhalide into a solid phase. That is, the production method may include producing the molybdenum oxyhalide by transferring the raw material containing molybdenum oxide through the reaction zone to which the halogen-containing gas is supplied; and cooling the produced gaseous molybdenum oxyhalide to collect the gaseous molybdenum oxyhalide into the solid phase.

In this case, a wall surface partitioning a space used for transferring the gaseous molybdenum oxyhalide discharged from the reaction zone may be heated. The wall surface may be heated to a temperature of 170 to 230°C, preferably 180 to 220°C, and more preferably 200 to 220°C. The wall surface partitioning the space used for transport may correspond to the first line described above.

The method for producing molybdenum oxyhalide may include S1) transferring a raw material containing molybdenum oxide to pass through a reaction zone to which a halogen-containing gas is supplied and energy is applied, and generating molybdenum oxyhalide, S2) receiving and cooling the gaseous molybdenum oxyhalide generated in step S1) and collecting the molybdenum oxyhalide into a solid phase, S3) sublimating the collected solid-phase molybdenum oxyhalide into a gas, and S4) solidifying the sublimated molybdenum oxyhalide.

The method for producing the molybdenum oxyhalide according to an example embodiment may continuously synthesize the molybdenum oxyhalide and continuously solidify the synthesized molybdenum oxyhalide by reaction of halogen-containing gas and molybdenum oxide, thereby producing the solid-phase molybdenum oxyhalide.

In the continuous production of the molybdenum oxyhalide described above, the production method according to an example embodiment may include: continuously supplying and transporting the raw material containing the molybdenum oxide to a reaction zone in which the halogen-containing gas is supplied and a constant temperature is maintained by the application of energy, so that the gaseous molybdenum oxyhalide is continuously synthesized while continuously passing through the reaction zone; continuously receiving and cooling a gas phase containing the continuously produced gaseous molybdenum oxyhalide to collect the molybdenum oxyhalide into the solid phase; sublimating the collected solid-phase molybdenum oxyhalide; and solidifying the sublimated molybdenum oxyhalide gas.

After the continuous synthesis of the molybdenum oxyhalide and the continuous collection into the solid phase, the solid-phase molybdenum oxyhalide is purified through the sublimation in step S3) and the solidification in step S4), thereby producing the molybdenum oxyhalide having improved purity as the final product.

By producing the molybdenum oxyhalide based on the continuous synthesis and continuous collection of the molybdenum oxyhalide, and the purification through the sublimation and solidification, commercial mass production of the molybdenum oxyhalide is enabled.

The method for producing molybdenum oxyhalide may further include, prior to step S1), heating the raw material and supplying the inert gas from which the moisture has been removed to the raw material. Through this, the raw material from which the moisture has been removed may be supplied to the reaction zone.

In step S1), the halogen-containing gas from which the moisture has been removed may be supplied to the reaction zone.

During the collection in step S2), the continuous collection may be performed on the molybdenum oxyhalide-containing gas in a heated state. Specifically, the molybdenum oxyhalide (g) produced in step S1) may be transferred to the collection unit for collection in step S2) in a state heated to a predetermined temperature T1, and the collection may be performed on the molybdenum oxyhalide-containing gas heated to the predetermined temperature T1. The heating of the transferred molybdenum oxyhalide-containing gas may be performed by heating a wall surface (corresponding to a first line) that partitions a space used for transferring the gaseous molybdenum oxyhalide discharged from the reaction zone.

During the sublimation in step S3), the solid-phase molybdenum oxyhalide in the heated state may be supplied and sublimated. Specifically, the solid-phase molybdenum oxyhalide (s) produced by the collection in step S2) may be transferred to the purification unit for sublimation in step S3) in a state heated to a predetermined temperature T2, and the sublimation may be performed on the molybdenum oxyhalide solid heated to the predetermined temperature T2. The heating of the molybdenum oxyhalide collected into the solid phase may be performed by heating the transfer means (corresponding to the purification transfer unit) for transferring the collected molybdenum.

During the solidification in step S4), the molybdenum oxyhalide gas in the heated state may be solidified. Specifically, the sublimated molybdenum oxyhalide (g) in step S3) may be transferred to the solidification unit in which the cooling for solidification in step S4) is performed, in a state heated to a predetermined temperature T3, and the solidification may be performed on the molybdenum oxyhalide (g) heated to the predetermined temperature T3. The heating of the sublimated molybdenum oxyhalide may be performed by heating a wall surface (corresponding to a second line) that partitions a space used for transferring the sublimated molybdenum oxyhalide. During the solidification in step S4), the solidification may be performed under the condition in which the thermal gradient is present from T3, which is a temperature of the transferred molybdenum oxyhalide (g), to the solidification temperature at which solidification occurs.

A step of adsorbing and removing halogen gas from residual gas remaining during and/or after the collection in step S2) and/or the solidification in step S4) may be further performed.

In an advantageous example, the temperature Trx, T1, and T3 of the reaction zone, and the sublimation temperature may be the same as each other, and the heating temperature of the raw material may also be the same as the temperature of the reaction zone. Through this, a constant thermal state (temperature) may be maintained without thermal fluctuation from the solid raw material to the gaseous intermediate product (synthesized the molybdenum oxyhalide, the sublimated molybdenum oxyhalide), except for cooling for the collection step or cooling for solidification.

As an example of the molybdenum dioxydichloride, which is useful as the precursor for depositing the molybdenum metal, the temperature Trx, T1, and T3 of the uniform zone, the sublimation temperature, and the heating temperature of the raw material may be the same at a temperature of 200 to 220°C.

As an example of the molybdenum dioxydichloride, which is useful as the precursor for depositing the molybdenum metal, the collection may be performed at atmospheric pressure and at a temperature of 20 to 120°C, preferably 60 to 110°C, and more preferably 90 to 110°C. The collected molybdenum dioxydichloride (s) may be heated and maintained at a temperature T2 of 50 to 120°C, specifically 80 to 120°C, and more specifically 100 to 120°C. The molybdenum dioxydichloride (s) heated and maintained at T2 may be sublimated by being heated to a temperature of 170 to 230°C, specifically 190 to 210°C. The solidification of the molybdenum heated and maintained at T3 may be performed at -30 to 20°C.

The space where steps S1) to S4) are performed may be positioned under the atmosphere in which the moisture has been removed. In this case, each space where steps S1) through S4) are performed may be interconnected on a gas phase basis and collectively referred to as a synthesis space. Accordingly, the synthesis space may be positioned under the atmosphere in which the moisture has been removed, specifically under dry air.

In the production apparatus or production method described above, the halogen-containing gas is the chlorine-containing gas, and the molybdenum oxyhalide may be the molybdenum dioxydichloride.

In the above-described production apparatus or production method, the molybdenum oxyhalide may be a precursor for depositing molybdenum metal. In this case, the deposition may include CVD, PECVD, or ALD, but is not limited thereto.

In the production apparatus or production method described above, the molybdenum oxyhalide may be a material for forming an electrode selected from one or more electrodes included in an electrode group consisting of an anode and a cathode of a diode and a source, a drain, and a gate of a transistor, or a material for forming a line selected from one or more lines included in a word line and a bit line of a memory device. In this case, the transistor may include a junction transistor or a field-effect transistor. The diode may include a p-n diode or a p-i-n diode. However, the above-described electrodes and lines indicate only preferred uses of the molybdenum oxyhalide and are not limited thereto. For example, the molybdenum oxyhalide may be a material for forming electrodes of various electronic devices and energy devices, such as electrodes of display devices and electrodes of energy generation devices such as solar cells.

According to an aspect of the present disclosure, there is provided molybdenum oxyhalide produced by the production method.

Hereinafter, an example is provided of producing the molybdenum dioxydichloride, as the final product, using the apparatus according to the schematic diagram of FIG. 10, in which the molybdenum dioxydichloride is useful as the precursor for depositing the molybdenum metal. In this case, the atmosphere inside the housing was in the dry air state (moisture content of 1 mass ppm or less). In this case, for easier understanding by those skilled in the art, although the supply condition of halogen elements satisfies knₕₐₗ to 10 knₕₐₗ moles as described above, the supply condition of the halogen-containing gas is expressed in terms of a volume of chlorine gas supplied per unit mass of molybdenum dioxide.

### (Example)

Molybdenum dioxide powder (having a size of 100 µm to 1 mm) was used as a raw material. The raw material was heated to a temperature of 200°C, and nitrogen gas from which moisture had been removed by a moisture adsorber was supplied to the raw material, thereby controlling a moisture content of the molybdenum dioxide to 100 ppm by mass or less.

As the halogen-containing gas, chlorine gas alone having a moisture content controlled to 1 ppm by mass or less by a moisture adsorber and a gas purifier, or a mixed gas formed by mixing chlorine gas and nitrogen gas each having moisture removed by a moisture adsorber, was supplied to a starting region of a uniform zone after the moisture content of the gas was further reduced to 1 ppm by mass or less by a gas purifier. In Table 1, an inert gas concentration (%) refers to a volume fraction of nitrogen gas contained in the mixed gas.

A raw material transfer rate V, a uniform zone temperature Tᵣₓ, a residue storage unit temperature Tᵣₑₛ, a first line temperature T_{L1}, a capture temperature (a cooling temperature by a first cooling unit, T_{Sol}), a purification transfer unit temperature (a temperature heated by a transfer heating unit, Tₜᵣₐ), a sublimation temperature (a temperature heated by a purification heating unit, T_{sub}), a second line temperature T_{L2}, a temperature heated by a solidification heating unit (T_{cryH}) / a solidification temperature (a cooling temperature by a first cooling unit, T_{cryL}), a volume of chlorine gas supplied per unit mass of molybdenum dioxide (HR), and a time required to pass through the uniform zone (Rx T) were summarized in Table 1.

**(Table 1)**

| | V (m/hr) | Tᵣₓ (°C) | Tᵣₑₛ (°C) | T_{L1} (°C) | T_{Sol} (°C) | Tₜᵣₐ (°C) | T_{sub} (°C) | T_{L2} (°C) | T_{cryH}/T_{cryL} (°C/°C) | HR (cc/g) | Rx T (min) | Inert gas concentration (%) |
|---|---|---|---|---|---|---|---|---|---|---|---|---|
| Example 1 | 0.6 | 200 | 200 | 200 | 25 | 100 | 200 | 200 | 200/-20 | 0.33 | 60 | 0 |
| Example 2 | 0.6 | 200 | 200 | 200 | 100 | 100 | 200 | 200 | 200/-20 | 0.33 | 60 | 0 |
| Example 3 | 0.6 | 170 | 200 | 200 | 25 | 100 | 200 | 200 | 200/-20 | 0.33 | 60 | 0 |
| Example 4 | 0.6 | 200 | 200 | 200 | 25 | 100 | 200 | 200 | 200/-20 | 0.08 | 60 | 0 |
| Example 5 | 0.6 | 200 | 200 | 200 | 25 | 100 | 200 | 200 | 200/-20 | 0.11 | 60 | 0 |
| Example 6 | 0.6 | 200 | 200 | 200 | 25 | 100 | 200 | 200 | 200/-20 | 0.66 | 60 | 0 |
| Example 7 | 0.6 | 200 | 200 | 200 | 100 | 100 | 200 | 200 | 200/-20 | 0.33 | 60 | 75 |
| Example 8 | 0.6 | 200 | 200 | 200 | 100 | 100 | 200 | 200 | 200/-20 | 0.33 | 60 | 50 |
| Example 9 | 0.6 | 200 | 200 | 200 | 100 | 100 | 200 | 200 | 200/-20 | 0.33 | 60 | 25 |

The density (density of the collected molybdenum dioxydichloride, den1) during the synthesis of the molybdenum dioxydichloride, the density of the final molybdenum dioxydichloride obtained by solidification den2, the production yield Y, purity P, moisture contamination M, and the production rate of the final molybdenum dioxydichloride were summarized in Table 2.

**(Table 2)**

| | Den1 (g/L) | Den2 (g/L) | Y (%) | P (%) | M **(**massₚₚₘ) | Production rate (g/hr) |
|---|---|---|---|---|---|---|
| Example 1 | 0.06 | 0.8 | 90 | ≥ 99.9996 | < 1 | 1.4 |
| Example 2 | 1.1 | 1.3 | 90 | ≥ 99.9996 | < 1 | 1.42 |
| Example 3 | 0.01 | - | 5 | - | < 1 | - |
| Example 4 | 0.061 | 0.78 | 48 | ≥ 99.9996 | < 1 | 0.2 |
| Example 5 | 0.062 | 0.61 | 70 | ≥ 99.9996 | < 1 | 0.6 |
| Example 6 | 0.06 | 0.81 | 90 | ≥ 99.9996 | < 1 | 3.0 |
| Example 7 | 0.061 | 0.77 | 90 | ≥ 99.9996 | < 1 | 1.45 |
| Example 8 | 0.062 | 0.80 | 90 | ≥ 99.9996 | < 1 | 1.42 |
| Example 9 | 0.061 | 0.79 | 90 | ≥ 99.9996 | < 1 | 1.43 |

For comparison, 1 g of molybdenum dioxide powder, heated to 200°C to remove moisture, was introduced into a batch-type reactor, and moisture-removed chlorine gas was injected at a rate of 20 cc/min, and a reaction was performed at 200°C for 60 minutes. Subsequently, the batch-type reactor was cooled to 25°C to obtain the solid-phase molybdenum dioxide, and the solid-phase molybdenum dioxide was transferred to the purification unit, sublimated at 200°C, and then solidified again at -20°C to obtain the final batch-produced molybdenum dioxydichloride. The batch-produced molybdenum dioxydichloride was severely contaminated by moisture, and a production yield thereof was only 85%. The above example embodiments are exemplary and should not be construed as limiting the present disclosure.

While example embodiments have been shown and described above, it will be apparent to those skilled in the art that modifications and variations could be made without departing from the scope of the present disclosure as defined by the appended claims.

## Claims

1. An apparatus for producing molybdenum oxyhalide, comprising:
a reaction zone to which a halogen-containing gas is supplied,
wherein a raw material containing molybdenum oxide is transferred so as to pass through the reaction zone, and
molybdenum oxyhalide is produced.

2. The apparatus of claim 1, wherein the raw material is transferred continuously.

3. The apparatus of claim 1, wherein an average transfer speed of the raw material passing through the reaction zone is 0.01 m/hr to 10.0 m/hr.

4. The apparatus of claim 1, wherein at least one energy selected from the group consisting of thermal energy, light energy, and vibrational energy is applied to the reaction zone.

5. The apparatus of claim 1, further comprising:
a case providing an internal space including the reaction zone, and
an energy application unit applying energy to the reaction zone.

6. The apparatus of claim 5, further comprising:
a transfer means transferring the raw material to pass through the reaction zone.

7. The apparatus of claim 6, wherein the transfer means includes a transfer shaft rotatably equipped with a transfer blade, or a belt moving in a designed direction.

8. The apparatus of claim 5, wherein a material of the case is a non-metallic inorganic material in a crystalline, amorphous, or a composite phase in which crystalline and amorphous phases are mixed.

9. The apparatus of claim 5, wherein, in the internal space, a partition wall for preventing gas backflow is provided in front of an inlet point where the halogen-containing gas is introduced, relative to a transfer direction of the raw material.

10. The apparatus of claim 1, further comprising:
a first gas supply unit including a first gas cylinder storing a halogen gas and a first moisture adsorber, and
a second gas supply unit including a second gas cylinder storing inert gas and a second moisture adsorber.

11. The apparatus of claim 10, further comprising:
a gas purifier removing moisture from the halogen-containing gas including a halogen gas supplied from the first gas supply unit and an inert gas supplied from the second gas supply unit.

12. The apparatus of claim 1, further comprising:
a residue storage unit for receiving and storing a residual solid phase discharged from the reaction unit, and a residue heating unit heating the residue storage unit.

13. The apparatus of claim 1, further comprising:
a collection unit receiving the gaseous molybdenum oxyhalide and collecting the gaseous molybdenum oxyhalide into a solid phase.

14. The apparatus of any one of claims 1 to 13, further comprising:
a heating unit heating a wall surface that contacts the gaseous molybdenum oxyhalide discharged from the reaction zone and partitions a space used for transferring or storing the gaseous molybdenum oxyhalide.

15. An apparatus for producing molybdenum oxyhalide, comprising:
a raw material supply unit supplying a raw material containing molybdenum oxide;
a reaction transfer unit including a reaction zone to which a halogen-containing gas is supplied and energy is applied, the raw material supplied from the raw material supply unit being transferred to pass through the reaction zone and molybdenum oxyhalide being produced;
a collection unit receiving gaseous molybdenum oxyhalide discharged from the reaction transfer unit and collecting the gaseous molybdenum oxyhalide into a solid phase;
a purification unit receiving the solid molybdenum oxyhalide collected in the collection unit and sublimating the received solid molybdenum oxyhalide into a gas; and
a solidification unit receiving and solidifying the sublimated molybdenum oxyhalide.

16. The apparatus of claim 15, further comprising:
a raw material heating unit heating the raw material within the raw material supply unit.

17. The apparatus of claim 15, further comprising:
a line heating unit heating at least one selected from the group consisting of:
a first line which is a transfer line between an outlet through which gaseous molybdenum oxyhalide is discharged from the reaction transfer unit and an inlet through which the gaseous phase is introduced to the collection unit;
a second line which is a transfer line between an outlet through which the sublimated molybdenum oxyhalide is discharged from the purification unit and an inlet through which the sublimated molybdenum oxyhalide is introduced to the solidification unit; and
a third line which is a transfer line between a solid outlet through which a residual solid phase is discharged from the reaction transfer unit and a solid inlet of a residue storage unit that receives and stores the residual solid phase.

18. The apparatus of claim 15, further comprising:
a purification transfer unit transferring the solid phase collected in the collection unit to the purification unit, and a transfer heating unit heating the purification transfer unit.

19. The apparatus of claim 15, wherein the solidification unit includes:
a solidification body having an internal space and provided with an inlet formed at an upper end portion thereof through which the sublimated molybdenum oxyhalide is introduced;
a cooling plate accommodated in the solidification body to cool the sublimated molybdenum oxyhalide; and
a solidification heating unit heating at least an upper end portion of the solidification body where the inlet is formed.

20. The apparatus of claim 15, further comprising:
a housing providing an internal space where the raw material supply unit, the reaction transfer unit, the collection unit, the purification unit, and the solidification unit are positioned; and
a moisture removal unit removing moisture from an atmosphere within the housing.

21. A method for producing molybdenum oxyhalide, comprising:
passing a raw material containing molybdenum oxide through a reaction zone;
supplying a halogen-containing gas to the reaction zone; and
generating molybdenum oxyhalide.

22. The method of claim 21, wherein the raw material flows and passes through the reaction zone.

23. The method of claim 21, wherein an average transfer speed of the raw material passing through the reaction zone is 0.01 m/hr to 10.0 m/hr.

24. The method of claim 21, wherein at least one energy selected from the group consisting of thermal energy, light energy, and vibrational energy is applied to the reaction zone.

25. The method of claim 21, wherein moisture is removed from the raw material before the raw material is supplied to the reaction zone.

26. The method of claim 21, wherein the halogen-containing gas is a mixed gas of halogen gas and inert gas, and moisture is removed from the mixed gas before the mixed gas is supplied to the reaction zone.

27. The method of claim 21, wherein a temperature of the reaction zone is 190 to 350°C.

28. The method of claim 21, wherein a time required for the raw material to pass through the reaction zone is 10 minutes to 600 minutes.

29. The method of claim 21, wherein the halogen-containing gas is supplied to the reaction zone such that, based on a stoichiometric ratio of the molybdenum oxyhalide, the number of moles of halogen atoms required to generate 1 mole of the molybdenum oxyhalide is set as the reference number of moles, and 1 to 10 times the reference number of moles of halogen element is supplied.

30. The method of claim 21, further comprising:
cooling the produced gaseous molybdenum oxyhalide and collecting the cooled molybdenum oxyhalide into a solid phase.

31. The method of claim 30, wherein the supply of the raw material to the reaction zone and the collection into the solid phase are performed simultaneously.

32. The method of claim 30, wherein a wall surface partitioning a space used for transferring the gaseous molybdenum oxyhalide discharged from the reaction zone is heated.

33. A method for producing molybdenum oxyhalide, comprising:
S1) transferring a raw material containing molybdenum oxide to pass through a reaction zone to which a halogen-containing gas is supplied and energy is applied, and generating molybdenum oxyhalide;
S2) receiving and cooling the gaseous molybdenum oxyhalide produced in step S1) and collecting the molybdenum oxyhalide into a solid phase;
S3) sublimating the collected solid molybdenum oxyhalide into a gas; and
S4) solidifying the sublimated molybdenum oxyhalide.

34. The method of claim 33, wherein, in S1), the raw material is continuously supplied to the reaction zone, and in S2), the gaseous molybdenum oxyhalide is continuously collected.

35. The method of claim 33, wherein one or more wall surfaces selected from the group consisting of a wall surface partitioning a space used for transferring the gaseous molybdenum oxyhalide discharged from the reaction zone and a wall surface partitioning a space used for transferring the sublimated molybdenum oxyhalide in S3) are heated.

36. The method of claim 33, wherein the molybdenum oxyhalide is heated when transferred to a purification unit where the sublimation of S3) of the molybdenum oxyhalide collected in the solid phase is performed.

37. The method of claim 33, wherein the space where S1) through S4) are performed is positioned under an atmosphere from which moisture is removed.

38. The method of any one of claims 21 to 37, wherein the halogen-containing gas is a chlorine-containing gas, and the molybdenum oxyhalide is molybdenum dioxydichloride.

39. The method of any one of claims 21 to 37, wherein the molybdenum oxide is molybdenum dioxide.

40. The method of any one of claims 21 to 37, wherein the molybdenum oxyhalide is a precursor for depositing molybdenum metal.

41. The method of any one of claims 21 to 37, wherein the molybdenum oxyhalide is a material for forming one or more electrodes selected from the group consisting of an anode and a cathode of a diode and a source, a drain, and a gate of a transistor; or a material for forming one or more lines selected from the group consisting of word lines and bit lines of a memory device.

42. Molybdenum oxyhalide produced by a production method of any one of claims 21 to 37.
